# EUROPEAN PATENT APPLICATION

(11) **EP 3 816 140 A1**
(43) Date of publication of application: **05.05.2021**
(21) Application number: 19815583.0
(22) Date of filing: 07.06.2019
(51) Int. Cl.: C04B 35/80, C04B 35/84, C23C 16/42

(54) **CERAMIC MATRIX COMPOSITE MATERIAL**

(30) Priority: 07.06.2018 JP 2018109789
(71) Applicant: IHI Corporation, Koto-ku Tokyo 135-8710 (JP)
(72) Inventor: TANAKA Yasutomo, Tokyo 135-8710 (JP); INOUE Hisato, Tokyo 135-8710 (JP); KUBOTA Wataru, Tokyo 135-8710 (JP); MATSUKURA Izumi, Tokyo 135-8710 (JP)
(74) Representative: Grünecker Patent- und Rechtsanwälte PartG mbB
(86) International application number: PCT/JP2019/022779
(87) International publication number: WO 2019/235624

(57) **Abstract**

A ceramic matrix composite of the present disclosure includes a fiber substrate including a silicon carbide fiber bundle, and a silicon carbide film formed on a surface of each silicon carbide fiber of the silicon carbide fiber bundle, in which a ratio of an average film thickness D₂ to an average film thickness D₁ is 1.0 to 1.3, the average film thickness D₁ being an average film thickness of the silicon carbide film formed on a surface of the silicon carbide fiber in an outer layer of the silicon carbide fiber bundle, and the average film thickness D₂ being an average film thickness of the silicon carbide film formed on a surface of the silicon carbide fiber in an inner layer, which is positioned inside the outer layer, of the silicon carbide fiber bundle.

## Description

### Technical Field

The present disclosure relates to a ceramic matrix composite.

Priority is claimed on Japanese Patent Application No. 2018-109789, filed June 7, 2018, the content of which is incorporated herein by reference.

### Background Art

Ceramic matrix composites (CMCs) are known as high-strength and high-temperature materials and as lightweight materials and are expected to be alternatives to nickel-based alloys. For example, by applying the CMC to high-temperature portions of aircraft jet engines, weight reduction and low-fuel consumption of the engine can be expected. When the CMC is applied to the high-temperature portions of the aircraft jet engines, it is effective to use silicon carbide having excellent heat resistance as a matrix.

For example, a CMC is produced by forming a silicon carbide film by depositing silicon carbide on a surface of each fiber of a fiber substrate using a chemical vapor deposition (CVD) method or a chemical vapor infiltration (CVI) method. Patent Document 1 discloses a CMC produced by allowing a raw material gas such as CH₃SiCl₃ (MTS) or SiCl₄, a carrier gas such as H₂ or He, and an additive gas such as C₂H₆ or C₂H₄ to flow into a reaction furnace and forming a silicon carbide film on a surface of a ceramic fiber using the CVD method or the CVI method.

### Document of Related Art

### Patent Document

[Patent Document 1] Japanese Patent No. 5906318

### Summary of Invention

### Technical Problem

Conventional CMCs such as those in Patent Document 1 do not have sufficient mechanical properties particularly when considering application to parts in harsh condition such as high-temperature portions of aircraft jet engines, and it is necessary to further improve the mechanical properties.

An object of the present disclosure is to provide a ceramic matrix composite having excellent mechanical properties.

### Solution to Problem

A ceramic matrix composite according to a first aspect of the present disclosure includes a fiber substrate including a silicon carbide fiber bundle, and a silicon carbide film formed on a surface of each silicon carbide fiber of the silicon carbide fiber bundle, in which a ratio of an average film thickness D₂ to an average film thickness D₁ is 1.0 to 1.3, the average film thickness D₁ being an average film thickness of the silicon carbide film formed on a surface of the silicon carbide fiber in an outer layer of the silicon carbide fiber bundle, and the average film thickness D₂ being an average film thickness of the silicon carbide film formed on a surface of the silicon carbide fiber in an inner layer, which is positioned inside the outer layer, of the silicon carbide fiber bundle.

In the ceramic matrix composite according to the first aspect of the present disclosure, the average film thickness D₂ of the silicon carbide film may be equal to or more than 2.6 µm.

### Effects of Invention

The ceramic matrix composite of the present disclosure has excellent mechanical properties.

### Brief Description of Drawings

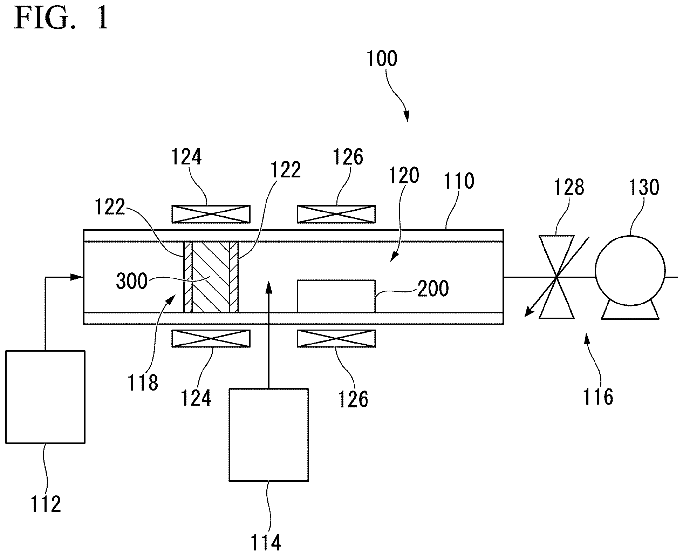

Fig. 1 is a schematic view showing an example of a manufacturing apparatus used for producing a ceramic matrix composite of the present disclosure.

### Description of Embodiments

A ceramic matrix composite (which will hereinafter be referred to as "CMC") of the present disclosure includes a fiber substrate including a silicon carbide fiber bundle and a silicon carbide film (SiC film) formed on a surface of each silicon carbide fiber of the silicon carbide fiber bundle.

The silicon carbide fiber bundle may include, in addition to the silicon carbide fiber, a fiber other than the silicon carbide fiber as long as it does not affect the effect of the present disclosure. Examples of the other fiber include an alumina fiber, a carbon fiber, a glass fiber and the like.

The content of the silicon carbide fiber in the silicon carbide fiber bundle may be equal to or more than 90 mass% of the total mass of the fibers contained in the silicon carbide fiber bundle, may be equal to or more than 95 mass% thereof, or may be 100 mass% thereof.

The number of the fibers, the fiber density, and the average distance between the fibers of the silicon carbide fiber bundle are not particularly limited, and can be appropriately set to be, for example, in a range generally set in CMC.

The form of the fiber substrate is not particularly limited, and examples thereof include textile fabrics such as plain weave fabric, twill weave fabric, satin weave fabric, and triaxial weave fabric.

The shape of the fiber substrate is not particularly limited, and can be appropriately selected depending on applications.

As the fiber substrate, a substrate in which powder is attached to the silicon carbide fiber bundle may also be used.

The type of the powder is not particularly limited, and known powder may be used as long as it does not affect the effect of the present disclosure. As the powder, one type of the powder may be used alone, or two or more types thereof may be used in combination.

In the CMC, the ratio (D₂/D₁) of an average film thickness D₂ to an average film thickness D₁ is within a range of 1.0 to 1.3, the average film thickness D₁ is an average film thickness of the silicon carbide film formed on the surface of the silicon carbide fiber in an outer layer (the outermost layer) of the silicon carbide fiber bundle, and the average film thickness D₂ is an average film thickness of the silicon carbide film formed on the surface of the silicon carbide fiber in an inner layer, which is positioned inside the outer layer, of the silicon carbide fiber bundle. Note that "the outer layer of the silicon carbide fiber bundle" means a region from the surface (the outer surface) of the silicon carbide fiber bundle to a depth of 20 µm. When D₂/D₁ is in the above-described range, the CMC in which the film is formed on the surface of each fiber of the silicon carbide fiber bundle has excellent mechanical properties.

The average film thickness D₁ of the silicon carbide film in the outer layer of the silicon carbide fiber bundle can be appropriately set as long as D₂/D₁ satisfies the above-described range. The larger the value of D₁, the higher the mechanical properties. An upper limit of D₁ may be selected based on the viewpoint of the productivity of the CMC.

The average film thickness D₂ of the silicon carbide film in the inner layer of the silicon carbide fiber bundle may be equal to or more than 2.6 µm, although it depends on the distance between the fibers in the silicon carbide fiber bundle. When D₂ is equal to or more than the lower limit of this range, the CMC has excellent mechanical properties. An upper limit of D₂ may be selected based on the viewpoint of the productivity of the CMC.

A production method for CMC of the present disclosure is not particularly limited. For example, a method of causing a silicon source gas containing SiCl₂ or SiCl and a carbon source gas containing a carbon atom to react with each other using a CVI method to form a silicon carbide film on the surface of each fiber of the silicon carbide fiber bundle in the fiber substrate may be employed. Since the infiltratability of silicon carbide into the silicon carbide fiber bundle is excellent when employing this method, it is possible to form a silicon carbide film having a sufficient film thickness even in the inner layer of the fiber bundle. Therefore, it is possible to easily control D₂/D₁ to be within the above-described range, and CMC having excellent mechanical properties can be produced.

The silicon source gas may be a gas containing SiCl₂ gas and not containing SiCl gas, or may be a gas containing both SiCl₂ gas and SiCl gas. When the silicon source gas contains the SiCl gas, the gas also contains the SiCl₂ gas in thermodynamic theory. The silicon source gas may contain a silicon source gas other than SiCl₂ and SiCl, such as SiCl₃ or SiCl₄.

When the silicon source gas contains SiCl₂, the partial pressure of the SiCl₂ gas when the total pressure of the gas is 1 atm (0.1 MPa) can be appropriately set. For example, the partial pressure of the SiCl₂ gas can be set from the viewpoint of ensuring uniformity and achieving productivity of the silicon carbide film formed on the surface of each fiber. The partial pressure of the SiCl₂ gas may be an upper limit of a thermodynamic theoretical value thereof.

When the silicon source gas contains SiCl, the partial pressure of the SiCl gas when the total pressure of the gas is 1 atm (0.1 MPa) can be appropriately set. For example, the partial pressure of the SiCl gas can be set from the viewpoint of ensuring uniformity and achieving productivity of the silicon carbide film formed on the surface of each fiber. The partial pressure of the SiCl gas may be an upper limit of a thermodynamic theoretical value thereof.

Examples of the chlorine source include gases such as Cl₂ gas, SiCl₄ gas, and MTS gas. The Cl₂ gas may be used as the chlorine source from the viewpoint that the Cl₂ gas does not contain a carbon atom (in this case, the carbon source can be separately supplied in a free amount ratio). As the chlorine source, one type of the chlorine source may be used alone, or two or more types thereof may be used in combination.

The partial pressure of the SiCl₂ gas or the SiCl gas in the silicon source gas can be adjusted by a temperature at which the silicon source and the chlorine source are brought into contact with each other.

Examples of the carbon source include hydrocarbons such as CH₄, C₂H₆, C₃H₈, C₂H₄, C₂H₂, C₆H₆, and CCl₄. As the carbon source, one type of the carbon source may be used alone, or two or more types thereof may be used in combination.

The carbon source may be at least one hydrocarbon of CH₄, C₂H₆, C₃H₈, C₂H₄, C₂H₂, C₆H₆, and CCl₄.

A carrier gas may be optionally used for a reaction for forming the silicon carbide film. Examples of the carrier gas include gases such as H₂ gas, N2 gas, He gas, and Ar gas, which are inert to the film forming reaction. The H₂ gas may be used as the carrier gas from the viewpoint of improving the infiltratability of silicon carbide into the silicon carbide fiber bundle.

As the carrier gas, one type of the carrier gas may be used alone, or two or more types thereof may be used in combination.

The reaction temperature of forming the silicon carbide film can be appropriately set. For example, a lower limit of the reaction temperature may be selected based on the viewpoint of the productivity of the CMC. An upper limit of the reaction temperature may be selected based on the viewpoint of improving the uniformity of the silicon carbide film formed on the surface of each surface.

The reaction pressure of forming the silicon carbide film may be 0.1 to 20 Torr (13 to 2660 Pa), may be 5 to 20 Torr (670 to 2660 Pa), or may be 15 to 20 Torr (2000 to 2660 Pa). When the reaction pressure is less than the lower limit of this range, there is a possibility that the infiltration rate is low and the productivity may be decreased. When the reaction pressure is more than the upper limit of this range, there is a possibility that the infiltration into the porous substrate is insufficient and the high-temperature strength may be decreased.

A manufacturing apparatus used for producing the CMC is not particularly limited. Examples thereof include a manufacturing apparatus 100 illustrated in Fig. 1. The figure illustrated in the following description is an example, and the present disclosure is not limited thereto and can be appropriately modified within a range where the scope of the present disclosure is not changed.

The manufacturing apparatus 100 includes a tubular reaction furnace 110, a chlorine source supply unit 112, a carbon source supply unit 114, and an exhaust unit 116. The reaction furnace 110 is provided with a first reaction section 118 and a second reaction section 120 in this order from the upstream side of the reaction furnace 110.

The first reaction section 118 is a section in which the silicon source is brought into contact with the chlorine source to react with each other.

The first reaction section 118 of this example is formed by partitioning the inside of the reaction furnace 110 by two partition members 122 and 122 which have gas permeability and are spaced apart from each other in a gas flow direction. A gap between the partition members 122 is filled with a solid silicon source 300 (Si powder). As the partition member 122, a member which does not allow the Si powder to pass through and allows the chlorine source gas and the silicon source gas as a product to pass through may be used, and examples thereof include carbon felt.

The first reaction section 118 of the reaction furnace 110 is provided with a first heater 124 for adjusting a temperature at which the silicon source and the chlorine source are brought into contact with each other.

The second reaction section 120 is a section in which the silicon source gas and the carbon source gas react to each other to form a silicon carbide film on a surface of each fiber of a fiber substrate 200. The form of the second reaction section 120 is not particularly limited as long as the fiber substrate 200 can be installed at a position where the silicon carbide film is formed on the surface of each fiber by the reaction between the silicon source gas and the carbon source gas.

The second reaction section 120 of the reaction furnace 110 is provided with a second heater 126 for adjusting the reaction temperature of the film formation.

The chlorine source supply unit 112 supplies the chlorine source gas. The chlorine source supply unit 112 supplies the chlorine source gas to a portion on the upstream side of the first reaction section 118 of the reaction furnace 110.

The carbon source supply unit 114 supplies the carbon source gas. The carbon source supply unit 114 supplies the carbon source gas to a portion between the first reaction section 118 and the second reaction section 120 of the reaction furnace 110. The carrier gas may be supplied together with the carbon source gas from the carbon source supply unit 114.

The exhaust unit 116 is provided on the downstream side of the reaction furnace 110 and includes a pressure regulating valve 128 and a vacuum pump 130. The exhaust unit 116 depressurizes the inside of the reaction furnace 110 by using the pressure regulating valve 128 and the vacuum pump 130 to adjust the pressure inside the reaction furnace 110 to a predetermined level.

In a method of producing CMC using the manufacturing apparatus 100, the chlorine source gas such as Cl₂ gas is supplied from the chlorine source supply unit 112 to the reaction furnace 110, and the chlorine source gas and the solid silicon are brought into contact with each other in the first reaction section 118. In the first reaction section 118, a silicon source gas containing SiCl₂ or SiCl is generated as a product by bringing the chlorine source gas and the solid silicon into contact with each other, and is sent to the second reaction section 120. In the second reaction section 120, the silicon source gas generated in the first reaction section 118 reacts with the carbon source gas that is supplied from the carbon source supply unit 114, and silicon carbide is deposited on the surface of each fiber of the fiber substrate 200 to form the silicon carbide film.

In the method of producing the CMC, after the silicon carbide film is formed by the CVI method, the matrix of silicon carbide may be formed by a polymer impregnation and pyrolysis (SPI) method or a melt infiltration (PIP) method. In this case, the average film thickness D₁ of the silicon carbide film in the outer layer of the silicon carbide fiber bundle and the average film thickness D₂ of the silicon carbide film in the inner layer of the silicon carbide fiber bundle are the average film thicknesses of the silicon carbide films formed by the CVI method.

When the cut surface of the CMC is observed with a microscope, the boundary between the silicon carbide film formed by the CVI method and the matrix formed by the SPI method or the PIP method is distinguishable. Therefore, D₁ and D₂ of the silicon carbide film can be measured even when the matrix is further formed by the SPI method or the PIP method.

It is considered that in a conventional CMC, because the infiltratability of silicon carbide into the silicon carbide fiber bundle is low and the uniformity of the silicon carbide film between the outer layer and the inner layer of the fiber bundle is low, it is difficult to obtain excellent mechanical properties.

On the other hand, in the CMC of the present disclosure, as the silicon carbide film formed on the surface of each fiber of the silicon carbide fiber bundle is controlled so that D₂/D₁ is within the specific range, the uniformity of the silicon carbide film between the outer layer and the inner layer of the fiber bundle is excellent. Therefore, the CMC of the present disclosure has excellent mechanical properties.

In addition, by setting D₂ to be equal to or more than 2.6 µm while controlling D₂/D₁, a silicon carbide film having a sufficient thickness is formed on the surface of each fiber in the inner layer of the silicon carbide fiber bundle, and accordingly it is possible to further improve mechanical properties.

### Industrial Applicability

The present disclosure can be applied to ceramic matrix composites.

### Description of Reference Signs

- 100: Manufacturing apparatus
- 110: Reaction furnace
- 112: Chlorine source supply unit
- 114: Carbon source supply unit
- 116: Exhaust unit
- 118: First reaction section
- 120: Second reaction section
- 122: Partition member
- 124: First heater
- 126: Second heater
- 128: Pressure regulating valve

- 130: Vacuum pump

## Claims

1. A ceramic matrix composite comprising:
a fiber substrate including a silicon carbide fiber bundle; and
a silicon carbide film formed on a surface of each silicon carbide fiber of the silicon carbide fiber bundle,
wherein a ratio of an average film thickness D₂ to an average film thickness D₁ is 1.0 to 1.3, the average film thickness D₁ being an average film thickness of the silicon carbide film formed on a surface of the silicon carbide fiber in an outer layer of the silicon carbide fiber bundle, and the average film thickness D₂ being an average film thickness of the silicon carbide film formed on a surface of the silicon carbide fiber in an inner layer, which is positioned inside the outer layer, of the silicon carbide fiber bundle.

2. The ceramic matrix composite according to claim 1, wherein the average film thickness D₂ of the silicon carbide film is equal to or more than 2.6 µm.
